(19) **Europäisches Patentamt / European Patent Office / Office européen des brevets**

(11) **EP 4 610 674 B1**

(12) **EUROPEAN PATENT SPECIFICATION**

(45) Date of publication and mention
of the grant of the patent:
**20.05.2026 Bulletin 2026/21**

(51) International Patent Classification (IPC):
**G01R 27/28** (2006.01)    **G01R 27/32** (2006.01)
**G01R 31/28** (2006.01)    **G01R 27/06** (2006.01)

(21) Application number: **24160272.1**

(22) Date of filing: **28.02.2024**

(52) Cooperative Patent Classification (CPC):
**G01R 27/28; G01R 27/32; G01R 31/2822;**
G01R 27/06

(54) **MEASUREMENT SYSTEM FOR ACTIVE LOAD PULL TESTING AND ACTIVE LOAD PULL MEASUREMENT METHOD**

MESSSYSTEM FÜR AKTIVE LASTZUGPRÜFUNG UND AKTIVES LASTZUGMESSVERFAHREN

SYSTÈME DE MESURE POUR TEST DE TRACTION DE CHARGE ACTIVE ET PROCÉDÉ DE MESURE DE TRACTION DE CHARGE ACTIVE

(84) Designated Contracting States:
**AL AT BE BG CY CZ DE DK EE ES FI FR GB GR HR HU IS IT LT LU LV MC ME MK MT NL NO PL PT RO RS SE SI SK SM TR**

(43) Date of publication of application:
**03.09.2025 Bulletin 2025/36**

(73) Proprietor: **Rohde & Schwarz GmbH & Co. KG**
**81671 München (DE)**

(72) Inventors:
• **Ramian, Florian**
  **81671 München (DE)**
• **Bednorz, Thilo**
  **81671 München (DE)**

(74) Representative: **Novagraaf Group**
**Chemin de l'Echo 3**
**1213 Onex / Geneva (CH)**

(56) References cited:
**US-A1- 2003 102 907    US-A1- 2007 182 424**

• **HASHMI M S ET AL: "Electronic multi-harmonic load-pull system for experimentally driven power amplifier design optimization", MICROWAVE SYMPOSIUM DIGEST, 2009. MTT '09. IEEE MTT-S INTERNATIONAL, IEEE, PISCATAWAY, NJ, USA, 7 June 2009 (2009-06-07), pages 1549 - 1552, XP031490827, ISBN: 978-1-4244-2803-8**
• **WILLIAMS T ET AL: "Experimental evaluation of an active envelope load pull architecture for high speed device characterization", 2005 IEEE MTT-S INTERNATIONAL MICROWAVE SYMPOSIUM, PISCATAWAY, NJ, USA,IEEE, 12 June 2005 (2005-06-12), pages 1509 - 1512, XP010844796, ISBN: 978-0-7803-8846-8, DOI: 10.1109/ MWSYM.2005.1516980**

**Description**

The present invention generally relates to a measurement system for active load pull testing. The present invention further relates to an active load pull measurement method.

Certain types of electronic devices under test, for example power amplifiers, need to be tested at a given impedance or over a given range of impedances.

Typically, measurement instruments are constructed for measurements at one specific impedance, which usually is 50 Ohm.

There are different techniques for adjusting the impedance. For example, the impedance presented to the device under test can be adjusted by a mechanical tuner, which is also known as a "passive load pull" technique.

As another example, the impedance presented to the device under test can be adjusted by measuring a signal received from the device under test and a signal transmitted to the device under test with two measurement receivers, and by generating a signal that is applied to the device under test based on the measured signals, such that a desired impedance is presented to the device under test. Examples of known load-pull systems are found in US 2007/182424 A1, US 2003/102907 A1, HASHMI M S ET AL: "Electronic multi-harmonic load-pull system for experimentally driven power amplifier design optimization", and in WILLIAMS T ET AL: "Experimental evaluation of an active envelope load pull architecture for high speed device characterization".

The known techniques described above require extra hardware in order to be performed compared to the usual measurement operations performed by the measurement instrument.

The object of the present invention is to provide a measurement system for active load pull testing and an active load pull measurement method that have reduced hardware requirements.

According to the present invention, the problem is solved by a measurement system for active load pull testing. The measurement system comprises a signal analysis module, a signal generator module, a control module, and a DUT connector. The DUT connector is connectable to a device under test in order to receive an output signal of the device under test. The signal analysis module is connected to the DUT connector, such that the signal analysis module receives a measurement signal corresponding to the output signal. The signal generator module is configured to generate a radio frequency, RF, test signal. The signal generator module is connected to the DUT connector, such that the RF test signal is applied to the device under test. The signal analysis module is configured to digitize the measurement signal, thereby obtaining a digitized measurement signal. The control module is configured to control the signal generator module to generate the RF test signal based on the digitized measurement signal, based on known error parameters of an error model of the measurement system, and based on a desired reflection coefficient at a reference plane associated with the device under test, wherein the error model describes transmissivity, reflectivity, and/or directivity properties of the measurement system with respect to the reference plane.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

Further, the term "error parameters" is understood to denote parameters of the error model describing transmissivity, reflectivity, and/or directivity properties of a portion of the measurement setup including the reference plane.

The measurement system according to the present invention is based on the idea to utilize the known error parameters of the error model in order to set the desired reflection coefficient at the reference plane.

For example, the known error parameters may have been determined in a previous calibration, which has to be performed for conducting tests on the device under test anyway.

Due to the utilization of the error model, it is not necessary to measure the RF test signal generated by the signal generator module. Instead, it is sufficient to measure the output signal of the device under test.

In fact, the properties of the output signal at the reference plane can be determined based on the digitized measurement signal and based on the error model.

Moreover, properties of the RF test signal transmitted at the reference plane can be determined based on the error model.

As the properties of the output signal of the device under test and of the RF test signal at the reference plane can be determined or rather calculated based on the error model, the appropriate RF test signal can be generated in order to present the desired reflection coefficient to the device under test at the reference plane.

In other words, by generating the RF test signal based on the digitized measurement signal, based on the known error parameters of the error model, and based on the desired reflection coefficient at the reference plane, a desired impedance can be presented to the device under test, i.e. the desired reflection coefficient is set at the reference plane.

Thus, fewer hardware components are necessary for active load pull measurements performed by the measurement system according to the present invention.

In fact, one measurement receiver is sufficient in the signal analysis module in order to set the desired reflection coefficient at the reference plane.

It is noted that, of course, the measurement system may comprise more than one measurement receiver. However, this is not necessary for the measurement system according to the present invention.

Further, it is noted that the measurement system may nonetheless comprise a passive load pull tuner, wherein the passive load pull tuner may be interconnected between the device under test and the DUT connector or may be provided between the DUT connector and the signal analysis module.

Generally, the reference plane may correspond to the plane at which the device under test is connected to the DUT connector.

A cable may be connected to the DUT connector, wherein the reference plane is located at an end of the cable facing away from the DUT connector. Thus, the error model describes transmissivity, reflectivity, and/or directivity properties of a portion of the measurement system including the DUT connector, the cable, and the reference plane. This way, the accuracy of a calibration and/or of subsequent measurements on the device under test can be enhanced, as connections within the measurement system, namely the cable, are taken into account in the error model.

According to an aspect of the present invention, the RF test signal is a modulated signal. Thus, the measurement system according to the present invention is also suitable for modulated S-parameter measurements.

Therein and in the following, the term "modulated signal" is understood to denote a signal with an amplitude, frequency and/or phase that is adapted over time. In other words, the modulated signal is not a pure continuous wave (CW) signal.

For example, the modulated signal may be a frequency sweep signal, wherein the frequency of an CW signal is adapted according to a predefined periodic function such as a sawtooth function.

In an embodiment of the present invention, the error model is an n-term error model, particularly a 4-term error model or an 8-term error model. Accordingly, the error model comprises n error parameters that need to be determined in order to calibrate the measurement system, i.e. the error terms comprise a total of n error parameters.

Therein, n is an integer greater than 1, particularly equal to or greater than 4.

For example, a 4-term error model may describe a single port.

As another example, an 8-term error model may describe two ports, particularly wherein one of the two ports is a driving port (i.e. is forwarding a signal to an external electronic device such as the device under test) and the other one of the two ports is a receiving port (i.e. is receiving a signal from an external electronic device such as the device under test).

However, it is to be understood that any other suitable error model may be used.

According to another aspect of the present invention, the error model is a two-port error model. Therein, one port of the error model may be associated with the signal generator module and/or the signal analysis module, while the other port of the error model may be associated with the reference plane. The error model describes transmissivity, reflectivity, and/or directivity properties within a portion of the measurement system modeled by the error model, namely a portion of the measurement system between the signal generator module and/or the signal analysis module and the reference plane.

In a further embodiment of the present invention, the error parameters are indicative of transmissivity, reflectivity properties, and/or directivity of the measurement system obtained by calibration measurements performed by the signal generator module. In other words, the error terms of the error model have been determined using the signal generator module as a calibration source.

In fact, any suitable calibration technique may be used in order to determine the error parameters. For example, a set of different calibration standards may be consecutively connected to the DUT connector at the reference plane, and corresponding measurements may be performed for each of the different calibration standards.

In a particular example, the set of calibration standards may comprise an "open" calibration standard, a "short" calibration standard, and a "matched" calibration standard (also known as "load" calibration standard). Thus, the calibration method used may be an OSM-calibration, which is also known as SOL-calibration.

Another aspect of the present invention provides that the measurement system further comprises an amplifier module, wherein the amplifier module is provided downstream of the signal generator module and upstream of the DUT connector, and wherein the amplifier module is configured to amplify the RF test signal. In other words, the amplifier module is located between the signal generator module and the DUT connector.

In order to set the desired reflection coefficient at the reference plane, a signal level of the RF test signal exceeding a maximum output level of the signal generator module may be necessary, i.e. the maximum output level of the signal generator may be insufficient. The amplifier module allows to amplify the RF test signal to the necessary signal level for presenting the desired reflection coefficient to the device under test at the reference plane.

In fact, the amplifier module may be provided separately from the signal generator module. For example, the amplifier module may be integrated on a separate integrated circuit board, e.g. on a card, that can be inserted into a measurement instrument comprising the signal generator module.

In other words, the measurement instrument may be retrofitted with the amplifier module by inserting the integrated circuit board comprising the amplifier module.

Particularly, the control module is configured to set an amplification factor to be applied by the amplifier module based on the digitized measurement signal, based on the known error parameters, and/or based on the desired reflection coefficient. More precisely, the amplification factor may be set such that the desired reflection coefficient is presented to the device under test at the reference plane.

In an embodiment of the present invention, the measurement system further comprises a switching module, wherein the switching module is configured to selectively couple the amplifier module into a signal path between the signal generator module and the DUT connector or to bypass the amplifier module. Accordingly, the amplifier module may be bypassed by the switching module if the maximum output level of the signal generator module is sufficient for presenting the desired reflection coefficient to the device under test. If the maximum output level of the signal generator module is insufficient for presenting the desired reflection coefficient to the device under test, the amplifier module may be coupled into the signal path between the signal generator module and the DUT connector by the switching module.

According to an aspect of the present invention, the measurement system further comprises a directional coupling unit, wherein the directional coupling unit is connected to the DUT connector, the signal analysis module, and the signal generator module. In fact, the directional coupling unit is configured to forward the RF test signal from the signal generator module to the DUT connector, such that the RF test signal is applied to the device under test at the reference plane. Further, the directional coupling unit is configured to forward the output signal of the device under test from the DUT connector to the signal analysis module.

In fact, the directional coupling unit may comprise an electric connection connecting the DUT connector and the signal analysis module, or an electric connection connecting the DUT connector and the signal generator module.

More precisely, the directional coupling unit may comprise the electric connection connecting the DUT connector and the signal analysis module, while an electromagnetic coupling is provided between the DUT connector and the signal generator module (but no electric connection between the DUT connector and the signal generator module). In this configuration, the signal-to-noise ratio (SNR) of the measurement signal is enhanced, as the direct electric connection typically causes less attenuation than the electromagnetic coupling.

Alternatively, the directional coupling unit may comprise the electric connection connecting the DUT connector and the signal generator module, while an electromagnetic coupling is provided between the DUT connector and the signal analysis module (but no electric connection between the DUT connector and the signal analysis module). In this configuration, the SNR of the RF test signal transmitted to the reference plane is enhanced, as the direct electric connection typically causes less attenuation than the electromagnetic coupling.

A further aspect of the present invention provides that the directional coupling unit is switchable between two operational modes, wherein the directional coupling unit comprises an electric connection connecting the DUT connector and the signal analysis module in a first operational mode, and wherein the directional coupling unit comprises an electric connection connecting the DUT connector and the signal generator module in a second operational mode. Accordingly, the measurement system is switchable between different operational modes providing high SNR for the measurement signal or for the RF test signal.

In an embodiment of the present invention, the measurement system further comprises an input module, wherein the input module is configured to receive a user input regarding the desired reflection coefficient. Accordingly, a user may set the desired reflection coefficient via the input module.

The input module may comprise a user interface, particularly a graphical user interface, and appropriate input means, such as a keyboard, a computer mouse, buttons, a touch-sensitive display or any other suitable type of input means.

In a particular example, the input module may be a network module that is configured to receive the user input via a network, particularly via a local area network, a wide area network, and/or via the internet. For example, the input module may receive the user input as standard commands for programmable instruments (SCPI).

The input module may further be configured to forward the user input regarding the desired reflection coefficient to the control module.

In a further embodiment of the present invention, the measurement system comprises a measurement instrument, wherein the measurement instrument comprises the signal generator module, the signal analysis module, and/or the DUT connector.

In fact, the measurement instrument may further comprise the directional coupling unit described above, the amplifier module described above, and/or the input module described above.

For example, the measurement instrument may be a vector network analyzer, a signal analyzer, a spectrum analyzer, or an oscilloscope.

However, it is to be understood that the measurement instrument may be established as any other suitable type of measurement instrument.

According to the invention, the problem further is solved by an active load pull measurement method. The active load pull measurement method comprises the steps of

- receiving an output signal of a device under test;

- receiving, by a signal analysis module, a measurement signal corresponding to the output signal;

- digitizing, by the signal analysis module, the measurement signal, thereby obtaining a digitized measurement signal;

- determining, by a control module, an RF test signal to be generated based on the digitized measurement signal, based on known error parameters of an error model of the measurement system, and based on a desired reflection coefficient at a reference plane associated with the device under test, wherein the error model describes transmissivity, reflectivity, and/or directivity properties of the measurement system with respect to the reference plane;

- controlling, by the control module, a signal generator module to generate the determined RF test signal; and

- applying the RF test signal to the device under test.

The measurement system described above, particularly the measurement system according to any one of the variants described above, may be configured to perform the active load pull measurement method.

Regarding the further advantages and properties of the active load pull measurement method, reference is made to the explanations given above with respect to the measurement system, which also hold for the active load pull measurement method and vice versa.

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows a first variant of a measurement system according to the present invention;
- Figure 2 schematically shows a second variant of a measurement system according to the present invention;
- Figure 3 shows a flow chart of an active load pull measurement method according to the present invention; and
- Figure 4 shows an error model describing a portion of the measurement system of Figure 1 or 2.

DETAILED DESCRIPTION

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

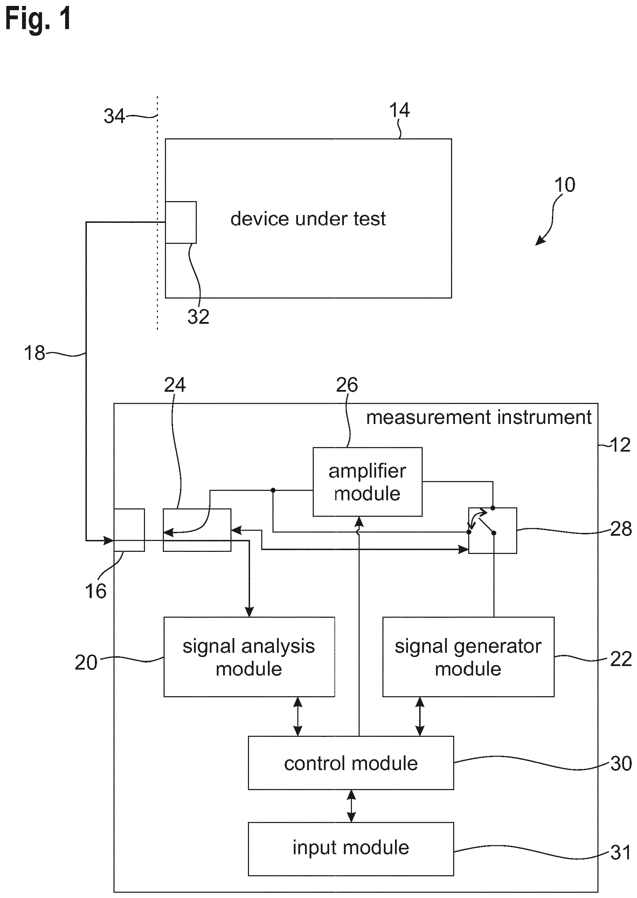

Figure 1 schematically shows a measurement system 10 comprising a measurement instrument 12 that is configured to perform active load pull measurements on a device under test 14.

In the exemplary embodiment shown in Figure 1, the measurement instrument 12 may be established as a signal analyzer, as a spectrum analyzer, or as an oscilloscope comprising a single DUT connector 16 that is connected to the device under test 14 via a cable 18.

However, it is to be understood that the measurement instrument 12 may be established as any other suitable type of measurement instrument comprising one or more ports, such as a vector network analyzer, a signal analyzer, a spectrum analyzer, or an oscilloscope having two or more ports.

Without restriction of generality, the exemplary embodiment shown in Figure 1 is described hereinafter.

The measurement instrument comprises a signal analysis module 20 and a signal generator module 22 that are each connected to the DUT connector 16.

In general, the signal analysis module 20 is configured to digitize and analyze received signals, as will be described in more detail below.

For example, the signal analysis module 20 may be or comprise a vector signal analyzer.

The signal generator module 22 is configured to generate RF test signals, as will be described in more detail below.

For example, the signal generator module 22 may be or comprise a vector signal generator and/or an arbitrary waveform generator.

The signal analysis module 20 and the signal generator module 22 are each connected to the DUT connector 16 via a directional coupling unit 24.

Therein, the directional coupling unit 24 is configured to forward an output signal of the device under test 14 received by the DUT connector 16 to the signal analysis module 20.

The directional coupling unit 24 is further configured to forward an RF test signal generated by the signal generator module 22 to the DUT connector 16, such that the RF test signal is forwarded to the device under test 14 via the DUT connector 16 and the cable 18.

In the exemplary embodiment shown in Figure 1, the directional coupling unit 24 comprises an electric connection connecting the DUT connector 16 and the signal analysis module 20, as well as an electromagnetic coupling between the DUT connector 16 and the signal generator module 22.

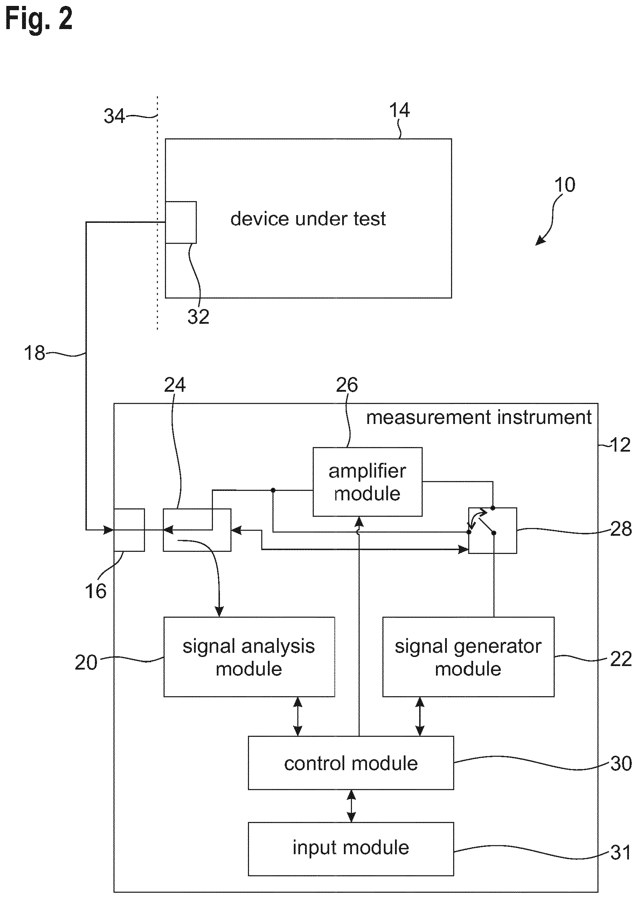

Alternatively, as is illustrated in Figure 2, the directional coupling unit 24 may comprise an electric connection connecting the DUT connector 16 and the signal generator module 22, as well as an electromagnetic coupling between the DUT connector 16 and the signal analysis module 20.

Optionally, an amplifier module 26 may be provided between the signal generator module 22 and the directional coupling unit 24, wherein the amplifier module 26 is configured to amplify the RF test signal generated by the signal generator module 22 by an adjustable amplification factor.

Further, a switching module 28 may provided, wherein the switching module 28 is configure to selectively couple the amplifier module 26 into a signal path between the signal generator module 22 and the DUT connector 16 or to bypass the amplifier module 26.

In fact, the amplifier module 26 and/or the switching module 28 may be provided separately from the signal generator module 22.

For example, the amplifier module 26 and/or the switching module 28 may be integrated on a separate integrated circuit board, e.g. on a card, that can be inserted into the measurement instrument 12.

Accordingly, the measurement instrument 12 can be retrofitted with the amplifier module 26 and/or with the switching module 28.

The measurement instrument 12 further comprises a control module 30 that is connected to the signal analysis module 20 and the signal generator module 22.

Optionally, the control module 30 may be connected to the directional coupling unit 24, the amplifier module 26, and/or the switching module 28.

In fact, the control module 30 may be configured to control the directional coupling unit 24 to switch between the two operational modes shown in Figures 1 and 2, respectively.

In the first operational mode shown in Figure 1, the directional coupling unit 24 comprises the electric connection connecting the DUT connector 16 and the signal analysis module 20.

In the second operational mode shown in Figure 2, the directional coupling unit 24 comprises the electric connection connecting the DUT connector 16 and the signal generator module 22.

Alternatively or additionally, the control module 30 may be configured to adapt the amplification factor of the amplifier module 26.

Alternatively or additionally, the control module 30 may be configured to control the switching module 28 to couple the amplifier module 26 into the signal path between the signal generator module 22 and the DUT connector 16, or to bypass the amplifier module 26.

The further functionality of the control module 30 will be described in more detail below.

The measurement instrument 12 may further comprise an input module 31 that is configured to receive a user input.

For example, the input module 31 may comprise a user interface, particularly a graphical user interface, and appropriate input means, such as a keyboard, a computer mouse, buttons, a touch-sensitive display or any other suitable type of input means.

In another example, the input module 31 may be a network module that is configured to receive the user input via a network, particularly via a local area network, a wide area network, and/or via the internet. For example, the input module 31 may receive the user input as standard commands for programmable instruments (SCPI).

The input module 31 is connected with the control module 30, such that the user input received by the input module 31 is forwarded to the control module 30.

The device under test 14 comprises an output port 32 that is connected to the DUT connector 16 via the cable 18.

More precisely, the device under test 14 is connected to the cable at a reference plane 34 that is located at an end of the cable 18 facing away from the DUT connector 16.

In general, the device under test 14 is configured to generate an output signal that is forwarded to the DUT connector 16 via the output port 32 and the cable 18.

For example, the device under test 14 may be a mobile communication device, such as a smartphone or a tablet.

While the device under test 14 is shown to be a single-port device in Figures 1 and 2, it is to be understood that the device under test 14 may likewise be established as a multiport device.

For example, the device under test 14 may be configured to receive an input signal via an input port, and to process the received input signal, thereby generating the output signal.

In a specific example, the device under test 14 may be an amplifier, a mixer, a filter, or any other type of electronic multiport device.

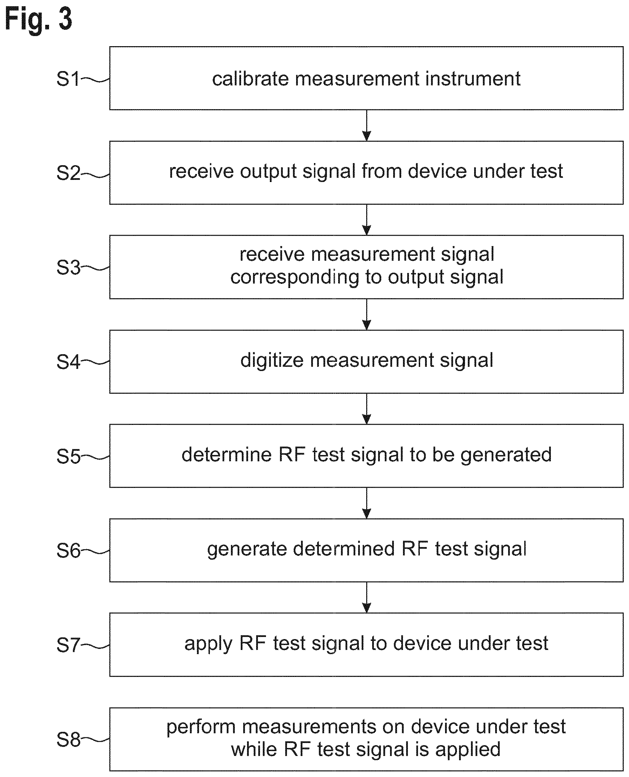

The measurement system 10, particularly the measurement instrument 12, is configured to perform an active load pull measurement method that is described hereinafter with reference to Figure 3, which shows a flow chart of the active load pull measurement method.

If a calibration of the measurement instrument 12 has not yet been performed, the measurement instrument 12 is calibrated, thereby determining error parameters of an error model (step S1).

Any suitable calibration technique may be used in order to determine the error parameters. For example, a set of different calibration standards may be consecutively connected to the DUT connector at the reference plane, and corresponding measurements may be performed for each of the different calibration standards.

In a particular example, the set of calibration standards may comprise an "open" calibration standard, a "short" calibration standard, and a "matched" calibration standard (also known as "load" calibration standard). Thus, the calibration method used may be an OSM-calibration, which is also known as SOL-calibration.

During the calibration, the signal generator module 22 is used as a calibration source, i.e. an RF test signal used for the calibration is generated by the signal generator module 22.

In general, the error model or rather the error parameters of the error model describe reflectivity, transmissivity, and/or directivity properties of a portion of the measurement system 10 between the reference plane 34 on one hand and the signal analysis module 20 and the signal generator module 22 on the other hand.

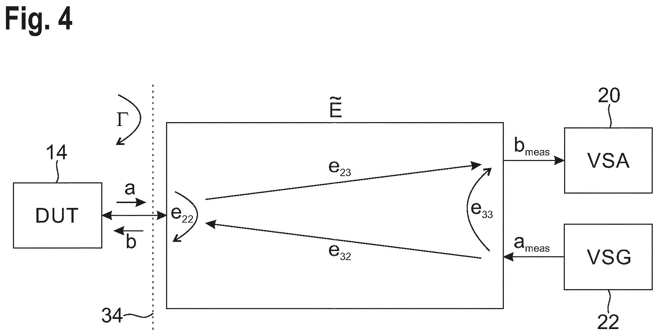

Figure 4 shows an exemplary error model. In this exemplary case, the multi-port error model is a 2-port error model with four error parameters $e_{22}$, $e_{33}$, $e_{32}$, and $e_{23}$, i.e. a 4-term error model.

However, it is to be understood that any other suitable multi-port error model may be used. In fact, the multi-port error model may be any suitable n-term error model comprising n error parameters.

The error terms $e_{22}$, $e_{33}$, $e_{32}$, and $e_{23}$ describe a reflection of the hardware components of the portion of the measurement system 10 described by the error model (also called "load match"), a transmission between the signal generator module 22 and the signal analysis module 20 (also called "directivity"), a transmission between the reference plane 34 and the signal analysis module 20 (also called "forward tracking"), and a transmission between the signal generator module 22 and the reference plane 34 (also called "reverse tracking"), respectively.

The multi-port error model can be expressed as

a matrix $\tilde{E} = \begin{pmatrix} e_{22} & e_{23} \\ e_{32} & e_{33} \end{pmatrix}$.

An output signal is received from the device under test (step S2).

In Figure 4, the output signal of the device under test 14 is denoted as "$a$", i.e. the signal "$a$" corresponds to the output signal of the device under test 14 at the reference plane 34.

A measurement signal corresponding to the output signal is received by the signal analysis module 20 (step S3).

In Figure 4, the measurement signal is denoted as "$b_{meas}$".

The output signal $a$ is forwarded to the signal analysis module 20 via the cable 18, the DUT connector 16, and the directional coupling unit 24, such that the output signal is altered due to the reflectivity, transmissivity, and directivity properties of the cable 18, the DUT connector 16, and the directional coupling unit 24.

Thus, the measurement signal $b_{meas}$ at the signal analysis module 20 is in general different from the output signal $a$ at the reference plane 34.

The measurement signal $b_{meas}$ is digitized by the signal analysis module 20, thereby obtaining a digitized measurement signal (step S4).

The digitized measurement signal is then forwarded to the control module 30.

An RF test signal $a_{meas}$ to be generated by the signal generator module 22 is determined by the control module 30 based on the known error parameters of the error model, and based on a desired reflection coefficient $\Gamma$ at the reference plane 34 (step S5).

The desired reflection coefficient $\Gamma$ describes an actual reflection coefficient presented to the device under test 14 at the reference plane 34, i.e. including the active load pull described hereinafter.

It is emphasized that the desired reflection coefficient $\Gamma$ is not equal to the load match $e_{22}$.

The desired reflection coefficient $\Gamma$ may be received from a user via the input module 31 and may be forwarded to the control module 30. In other words, the user may set the desired reflection coefficient via the input module 31.

The RF test signal $a_{meas}$ to be generated can be determined as described hereinafter.

As the error parameters of the error model $\tilde{E}$ are known, the output signal $a$ received from the device under test 14 at the reference plane 34 can be determined based on the digitized measurement signal, i.e. based on the measurement signal $b_{meas}$, and based on the known error parameters $e_{22}$, $e_{33}$, $e_{32}$, and $e_{23}$.

The RF test signal $b$ to be applied to the device under test 14 at the reference plane 34 is given by $b = \Gamma \cdot a$, wherein $\Gamma$ and $a$ are already known.

As the error parameters of the error model $\tilde{E}$ are known, the RF test signal $a_{meas}$ to be generated can then be determined based on $b = \Gamma \cdot a$ and based on the error parameters of the error model.

Therein, the determined RF test signal $a_{meas}$ may be a modulated signal.

The signal generator module 22 is controlled by the control module 30 to generate the determined RF test signal $a_{meas}$ (step S6).

The RF test signal $a_{meas}$ is forwarded to the reference plane 34 via the directional coupling unit 24, the DUT connector 16, and the cable 18.

If a maximum output level of the signal generator module is insufficient to obtain the RF test signal $b$ at the reference plane 34, the RF test signal $a_{meas}$ generated by the signal generator module 22 may be amplified by the amplifier module 26.

Particularly, the control module 30 may control the amplifier module 26 to set an appropriate amplification factor.

Alternatively or additionally, the control module 30 may control the switching module 28 to couple the amplifier module 26 into the signal path between the signal generator module 22 and the DUT connector 16.

The RF test signal $b$ corresponding to the generated RF test signal $a_{meas}$ is applied to the device under test 14 at the reference plane 34 (step S7).

Accordingly, the desired reflection coefficient $\Gamma$

is presented to the device under test 14 at the reference plane 34.

In other words, a desired impedance is presented to the device under test 14 at the reference plane 34.

Further measurements may be performed on output signals received from the device under test 14 while the RF test signal is applied to the device under test (step S8).

The further measurements may be performed by the signal analysis module 20.

Accordingly, a performance of the device under test 14 can be assessed while the desired reflection coefficient corresponding to the desired impedance is presented to the device under test 14.

In other words, active load pull measurements may be performed.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A measurement system for active load pull testing, wherein the measurement system (10) comprises a signal analysis module (20), a signal generator module (22), a control module (30), and a DUT connector (16),

   wherein the DUT connector (16) is connectable to a device under test (14) in order to receive an output signal of the device under test (14), wherein the signal analysis module (20) is connected to the DUT connector (16), such that the signal analysis module (20) receives a measurement signal corresponding to the output signal, wherein the signal generator module (22) is configured to generate a radio frequency, RF, test signal, wherein the signal generator module (22) is connected to the DUT connector (16), such that the RF test signal is applied to the device under test (14), wherein the signal analysis module (20) is configured to digitize the measurement signal, thereby obtaining a digitized measurement signal, and **characterized in that** the control module (30) is configured to control the signal generator module (22) to generate the RF test signal based on the digitized measurement signal, based on known error parameters of an error model of the measurement system (10), and based on a desired reflection coefficient at a reference plane (34) associated with the device under test (14), wherein the error model describes transmissivity, reflectivity, and/or directivity properties of the measurement system (10) with respect to the reference plane (34).

2. The measurement system of claim 1, wherein the RF test signal is a modulated signal.

3. The measurement system according to any one of the preceding claims, wherein the error model is an n-term error model, particularly a 4-term error model or an 8-term error model.

4. The measurement system according to any one of the preceding claims, wherein the error model is a two-port error model.

5. The measurement system according to any one of the preceding claims, wherein the error parameters are indicative of transmissivity, reflectivity, and/or directivity properties of the measurement system (10) obtained by calibration measurements performed by the signal generator module (22).

6. The measurement system according to any one of the preceding claims, wherein the measurement system (10) further comprises an amplifier module (26), wherein the amplifier module (26) is provided downstream of the signal generator module (22) and upstream of the DUT connector (16), and wherein the amplifier module (26) is configured to amplify the RF test signal.

7. The measurement system of claim 6, wherein the control module (30) is configured to set an amplification factor to be applied by the amplifier module (26) based on the digitized measurement signal, based on the known error parameters, and/or based on the desired reflection coefficient.

8. The measurement system of claim 6 or 7, wherein the measurement system (10) further comprises a switching module (28), wherein the switching module (28) is configured to selectively couple the amplifier module (26) into a signal path between the signal generator module (22) and the DUT connector (16) or to bypass the amplifier module (26).

9. The measurement system according to any one of the preceding claims, wherein the measurement system (10) further comprises a directional coupling unit (24), wherein the directional coupling unit (24) is connected to the DUT connector (16), the signal analysis module (20), and the signal generator module (22).

10. The measurement system of claim 9, wherein the directional coupling unit (24) comprises an electric connection connecting the DUT connector (16) and the signal analysis module (20), or an electric connection connecting the DUT connector (16) and the signal generator module (22).

11. The measurement system of claim 9 or 10, wherein the directional coupling unit (24) is switchable between two operational modes, wherein the directional coupling unit (24) comprises an electric connection connecting the DUT connector (16) and the signal analysis module (20) in a first operational mode, and wherein the directional coupling unit (24) comprises an electric connection connecting the DUT connector (16) and the signal generator module (22) in a second operational mode.

12. The measurement system according to any one of the preceding claims, wherein the measurement system (10) further comprises an input module (31), wherein the input module (31) is configured to receive a user input regarding the desired reflection coefficient.

13. The measurement system according to any one of the preceding claims, wherein the measurement system (10) comprises a measurement instrument (12), wherein the measurement instrument (12) comprises the signal generator module (22), the signal analysis module (20), and/or the DUT connector (16).

14. The measurement system of claim 13, wherein the measurement instrument (12) is a vector network analyzer, a signal analyzer, a spectrum analyzer, or an oscilloscope.

15. An active load pull measurement method, the active load pull measurement method comprising the steps of

- receiving an output signal of a device under test (14);
- receiving, by a signal analysis module (20), a measurement signal corresponding to the output signal;
- digitizing, by the signal analysis module (20), the measurement signal, thereby obtaining a digitized measurement signal;

**characterized by** the steps

- determining, by a control module (30), an RF test signal to be generated based on the digitized measurement signal, based on known error parameters of an error model of the measurement system (10), and based on a desired reflection coefficient at a reference plane (34) associated with the device under test (14), wherein the error model describes transmissivity, reflectivity, and/or directivity properties of the measurement system (10) with respect to the reference plane (34);
- controlling, by the control module (30), a signal generator module (22) to generate the determined RF test signal; and
- applying the RF test signal to the device under test (14).

**Patentansprüche**

1. Messsystem für ein aktives Load-Pull-Testen, wobei das Messsystem (10) ein Signalanalysemodul (20), ein Signalgeneratormodul (22), ein Steuermodul (30) und einen DUT-Verbinder (16) umfasst,

wobei der DUT-Verbinder (16) mit einem Prüfling (14) verbindbar ist, um ein Ausgangssignal des Prüflings (14) zu empfangen,

wobei das Signalanalysemodul (20) mit der DUT-Verbindung (16) verbunden ist, derart, dass das Signalanalysemodul (20) ein Messsignal, das dem Ausgangssignal entspricht, empfängt,

wobei das Signalgeneratormodul (22) konfiguriert ist, um ein Hochfrequenz-Testsignal, HF-Testsignal, zu generieren,

wobei das Signalgeneratormodul (22) mit dem DUT-Verbinder (16) verbunden ist, derart, dass das HF-Testsignal an den Prüfling (14) angelegt wird,

wobei das Signalanalysemodul (20) konfiguriert ist, um das Messsignal zu digitalisieren, wodurch ein digitalisiertes Messsignal erhalten wird, und

**dadurch gekennzeichnet, dass**

das Steuermodul (30) konfiguriert ist, um das Signalgeneratormodul (22) zu steuern, um das HF-Testsignal basierend auf dem digitalisierten Messsignal, basierend auf bekannten Fehlerparametern eines Fehlermodells des Messsystems (10) und basierend auf einem gewünschten Reflexionskoeffizienten an einer Referenzebene (34), die mit dem Prüfling (14) verknüpft ist, zu generieren, wobei das Fehlermodell Transmissivitäts-, Reflexivitäts- und/oder Richtwirkungseigenschaften des Messsystems (10) in Bezug auf die Referenzebene (34) beschreibt.

2. Messsystem nach Anspruch 1, wobei das HF-Testsignal ein moduliertes Signal ist.

3. Messsystem nach einem der vorstehenden Ansprüche, wobei das Fehlermodell ein n-Term-Fehlermodell, insbesondere ein 4-Term-Fehlermodell oder ein 8-Term-Fehlermodell, ist.

4. Messsystem nach einem der vorstehenden Ansprüche, wobei das Fehlermodell ein Zwei-Port-Fehlermodell ist.

5. Messsystem nach einem der vorstehenden Ansprüche, wobei die Fehlerparameter Transmissivitäts-, Reflektivitäts- und/oder Richtwirkungseigenschaften des Messsystems (10) angeben, die durch Kalibrierungsmessungen erhalten werden, die durch das Signalgeneratormodul (22) durchgeführt werden.

6. Messsystem nach einem der vorstehenden Ansprüche, wobei das Messsystem (10) ferner ein Verstärkermodul (26) umfasst, wobei das Verstärkermodul (26) stromabwärts des Signalgeneratormoduls (22) und stromaufwärts des DUT-Verbinders (16) bereitgestellt ist, und wobei das Verstärkermodul (26) konfiguriert ist, um das HF-Testsignal zu verstärken.

7. Messsystem nach Anspruch 6, wobei das Steuermodul (30) konfiguriert ist, um einen Verstärkungsfaktor einzustellen, der durch das Verstärkermodul (26) anzuwenden ist, basierend auf dem digitalisierten Messsignal, basierend auf den bekannten Fehlerparametern und/oder basierend auf dem gewünschten Reflexionskoeffizienten.

8. Messsystem nach Anspruch 6 oder 7, wobei das Messsystem (10) ferner ein Schaltmodul (28) umfasst, wobei das Schaltmodul (28) konfiguriert ist, um das Verstärkermodul (26) in einen Signalweg zwischen dem Signalgeneratormodul (22) und dem DUT-Verbinder (16) selektiv zu koppeln oder das Verstärkermodul (26) zu umgehen.

9. Messsystem nach einem der vorstehenden Ansprüche, wobei das Messsystem (10) ferner eine Richtkopplungseinheit (24) umfasst, wobei die Richtkopplungseinheit (24) mit dem DUT-Verbinder (16), dem Signalanalysemodul (20) und dem Signalgeneratormodul (22) verbunden ist.

10. Messsystem nach Anspruch 9, wobei die Richtkopplungseinheit (24) eine elektrische Verbindung, die den DUT-Verbinder (16) und das Signalanalysemodul (20) verbindet, oder eine elektrische Verbindung, die den DUT-Verbinder (16) und das Signalgeneratormodul (22) verbindet, umfasst.

11. Messsystem nach Anspruch 9 oder 10, wobei die Richtkopplungseinheit (24) zwischen zwei Betriebsmodi schaltbar ist, wobei die Richtkopplungseinheit (24) eine elektrische Verbindung umfasst, die den DUT-Verbinder (16) und das Signalanalysemodul (20) in einem ersten Betriebsmodus verbindet, und wobei die Richtkopplungseinheit (24) eine elektrische Verbindung umfasst, die den DUT-Verbinder (16) und das Signalgeneratormodul (22) in einem zweiten Betriebsmodus verbindet.

12. Messsystem nach einem der vorstehenden Ansprüche, wobei das Messsystem (10) ferner ein Eingabemodul (31) umfasst, wobei das Eingabemodul (31) konfiguriert ist, um eine Benutzereingabe bezüglich des gewünschten Reflexionskoeffizienten zu empfangen.

13. Messsystem nach einem der vorstehenden Ansprüche, wobei das Messsystem (10) ein Messinstrument (12) umfasst, wobei das Messinstrument (12) das Signalgeneratormodul (22), das Signalanalysemodul (20) und/oder den DUT-Verbinder (16) umfasst.

**14.** Messsystem nach Anspruch 13, wobei das Messinstrument (12) ein Vektor-Netzwerkanalysator, ein Signalanalysator, ein Spektrumanalysator oder ein Oszilloskop ist.

**15.** Aktives Lastzugmessungsverfahren, das aktive Lastzugmessungsverfahren umfassend die Schritte

- Empfangen eines Ausgangssignals eines Prüflings (14);
- Empfangen, durch ein Signalanalysemodul (20), eines Messsignals, das dem Ausgangssignal entspricht;
- Digitalisieren, durch das Signalanalysemodul (20), des Messsignals, wodurch ein digitalisiertes Messsignal erhalten wird;

**gekennzeichnet durch** die Schritte

- Bestimmen, durch ein Steuermodul (30), eines zu generierenden HF-Testsignals basierend auf dem digitalisierten Messsignal, basierend auf bekannten Fehlerparametern eines Fehlermodells des Messsystems (10) und basierend auf einem gewünschten Reflexionskoeffizienten an einer Referenzebene (34), die mit dem Prüfling (14) verknüpft ist, wobei das Fehlermodell Transmissivitäts-, Reflektivitäts- und/oder Richtwirkungseigenschaften des Messsystems (10) in Bezug auf die Referenzebene (34) beschreibt;
- Steuern, durch das Steuermodul (30), eines Signalgeneratormoduls (22), um das bestimmte HF-Testsignal zu generieren; und
- Anwenden des HF-Testsignals an dem Prüfling (14).

**Revendications**

**1.** Système de mesure pour test de traction de charge (load-pull) active, dans lequel le système de mesure (10) comprend un module d'analyse de signal (20), un module générateur de signal (22), un module de commande (30) et un connecteur DUT (16),

dans lequel le connecteur DUT (16) peut être connecté à un dispositif soumis à un test (14) afin de recevoir un signal de sortie du dispositif soumis au test (14),
dans lequel le module d'analyse de signal (20) est connecté au connecteur DUT (16), de sorte que le module d'analyse de signal (20) reçoit un signal de mesure correspondant au signal de sortie,
dans lequel le module générateur de signal (22) est configuré pour générer un signal de test radiofréquence, RF,

dans lequel le module générateur de signal (22) est connecté au connecteur DUT (16), de telle sorte que le signal dee test RF est appliqué au dispositif soumis au test (14),
dans lequel le module d'analyse de signal (20) est configuré pour numériser le signal de mesure, ce qui permet d'obtenir un signal de mesure numérisé, et
**caractérisé en ce que**
le module de commande (30) est configuré pour commander le module générateur de signal (22) afin de générer le signal de test RF en fonction du signal de mesure numérisé, en fonction de paramètres d'erreur connus d'un modèle d'erreur du système de mesure (10), et en fonction d'un coefficient de réflexion souhaité au niveau d'un plan de référence (34) associé au dispositif soumis au test (14), dans lequel le modèle d'erreur décrit des propriétés de transmissivité, de réflectivité et/ou de directivité du système de mesure (10) par rapport au plan de référence (34).

**2.** Système de mesure selon la revendication 1, dans lequel le signal de test RF est un signal modulé.

**3.** Système de mesure selon l'une quelconque des revendications précédentes, dans lequel le modèle d'erreur est un modèle d'erreur à n termes, en particulier un modèle d'erreur à 4 termes ou un modèle d'erreur à 8 termes.

**4.** Système de mesure selon l'une quelconque des revendications précédentes, dans lequel le modèle d'erreur est un modèle d'erreur à deux ports.

**5.** Système de mesure selon l'une quelconque des revendications précédentes, dans lequel les paramètres d'erreur sont indicatifs de propriétés de transmissivité, de réflectivité et/ou de directivité du système de mesure (10) obtenues par des mesures d'étalonnage mises en œuvre par le module générateur de signal (22).

**6.** Système de mesure selon l'une quelconque des revendications précédentes, dans lequel le système de mesure (10) comprend en outre un module amplificateur (26), dans lequel le module amplificateur (26) est fourni en aval du module générateur de signal (22) et en amont du connecteur DUT (16), et dans lequel le module amplificateur (26) est configuré pour amplifier le signal de test RF.

**7.** Système de mesure selon la revendication 6, dans lequel le module de commande (30) est configuré pour régler un facteur d'amplification à appliquer par le module amplificateur (26) en fonction du signal de mesure numérisé, en fonction des paramètres d'erreur connus, et/ou en fonction du coefficient de réflexion souhaité.

8. Système de mesure selon la revendication 6 ou 7, dans lequel le système de mesure (10) comprend en outre un module de commutation (28), dans lequel le module de commutation (28) est configuré pour coupler sélectivement le module amplificateur (26) dans un trajet de signal entre le module générateur de signal (22) et le connecteur DUT (16) ou pour contourner le module amplificateur (26).

9. Système de mesure selon l'une quelconque des revendications précédentes, dans lequel le système de mesure (10) comprend en outre une unité de couplage directionnel (24), dans lequel l'unité de couplage directionnel (24) est connectée au connecteur DUT (16), au module d'analyse de signal (20) et au module générateur de signal (22).

10. Système de mesure selon la revendication 9, dans lequel l'unité de couplage directionnel (24) comprend une connexion électrique connectant le connecteur DUT (16) et le module d'analyse de signal (20), ou une connexion électrique connectant le connecteur DUT (16) et le module générateur de signal (22).

11. Système de mesure selon la revendication 9 ou 10, dans lequel l'unité de couplage directionnel (24) est commutable entre deux modes fonctionnels, dans lequel l'unité de couplage directionnel (24) comprend une connexion électrique connectant le connecteur DUT (16) et le module d'analyse de signal (20) dans un premier mode fonctionnel, et dans lequel l'unité de couplage directionnel (24) comprend une connexion électrique connectant le connecteur DUT (16) et le module générateur de signal (22) dans un second mode fonctionnel.

12. Système de mesure selon l'une quelconque des revendications précédentes, dans lequel le système de mesure (10) comprend en outre un module d'entrée (31), dans lequel le module d'entrée (31) est configuré pour recevoir une entrée utilisateur concernant le coefficient de réflexion souhaité.

13. Système de mesure selon l'une quelconque des revendications précédentes, dans lequel le système de mesure (10) comprend un instrument de mesure (12), dans lequel l'instrument de mesure (12) comprend le module générateur de signal (22), le module d'analyse de signal (20), et/ou le connecteur DUT (16).

14. Système de mesure selon la revendication 13, dans lequel l'instrument de mesure (12) est un analyseur de réseau vectoriel, un analyseur de signal, un analyseur de spectre, ou un oscilloscope.

15. Procédé de mesure de traction de charge (load-pull) active, le procédé de mesure de traction de charge (load-pull) active comprenant les étapes de

- réception d'un signal de sortie d'un dispositif soumis au test (14) ;
- réception, par un module d'analyse de signal (20), d'un signal de mesure correspondant au signal de sortie ;
- numérisation, au moyen de la première unité de mesure (20), du signal de mesure analogique, ce qui permet d'obtenir un signal de mesure numérisé ;

**caractérisé par** les étapes

- de détermination, par un module de commande (30), d'un signal de test RF à générer en fonction du signal de mesure numérisé, en fonction de paramètres d'erreur connus d'un modèle d'erreur du système de mesure (10), et en fonction d'un coefficient de réflexion souhaité au niveau d'un plan de référence (34) associé au dispositif soumis au test (14), dans lequel le modèle d'erreur décrit des propriétés de transmissivité, de réflectivité, et/ou de directivité du système de mesure (10) par rapport au plan de référence (34) ;
- de commande, par le module de commande (30), d'un module générateur de signal (22) pour générer le signal de test RF déterminé ; et
- d'application du signal de test RF au dispositif soumis au test (14).

**Fig. 1**

# Fig. 2

# Fig. 3

S1 — | calibrate measurement instrument |

S2 — | receive output signal from device under test |

S3 — | receive measurement signal corresponding to output signal |

S4 — | digitize measurement signal |

S5 — | determine RF test signal to be generated |

S6 — | generate determined RF test signal |

S7 — | apply RF test signal to device under test |

S8 — | perform measurements on device under test while RF test signal is applied |

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007182424 A1

- US 2003102907 A1

**Non-patent literature cited in the description**

- **HASHMI M S et al.** *Electronic multi-harmonic load-pull system for experimentally driven power amplifier design optimization*

- **WILLIAMS T et al.** *Experimental evaluation of an active envelope load pull architecture for high speed device characterization*